# EUROPÄISCHE PATENTANMELDUNG

(11) **EP 0 791 835 A2**
(43) Veröffentlichungstag der Anmeldung: **27.08.1997**
(21) Anmeldenummer: 97102774.3
(22) Anmeldetag: 20.02.1997
(51) Int. Cl.: G01R 31/12

(54) **Laborprüfgerät zur Ermittlung der Isolierqualität eines daran zu Prüfzwecken anschliessbaren Verbrauchers**

(30) Priorität: 20.02.1996 DE 19606122
(71) Anmelder: GOSSEN-METRAWATT Gesellschaft mit beschränkter Haftung, D-90471 Nürnberg (DE)
(72) Erfinder: Krien, Burkhard, 91154 Roth (DE); Zeigler, Herbert, 90482 Nürnberg (DE)
(74) Vertreter: Hafner, Dieter, Dr.rer.nat., Dipl.-Phys.

(57) **Zusammenfassung**

Die Erfindung betrifft ein Laborprüfgerät 1 zur Ermittlung der Isolationsqualität eines daran zu Prüfzwecken anschließbaren Verbrauchers 2 mit einer Kontakteinrichtung 3 (Steckdose, Steckbuchsen, Klemmen) zum Anschluß des zu vermessenden Verbrauchers 2 und einem Ringkernwandler 4 zur Durchführung eines Differenzstromverfahrens, durch den das zur Kontakteinrichtung 3 verlaufende stromführende Element 5 hindurch geführt ist und dessen Ausgangsanschlüsse 6 mit einer Auswerte- oder Anzeigeeinrichtung 7 verbunden sind, um ein bei der Differenzstrommessung erzeugtes Induktionsspannungssignal als Maß der Isolationsqualität des anschließbaren Verbrauchers 2 anzeigen zu können, wobei der durch den Ringkernwandler 4 hindurchgehende Abschnitt 8 des stromführenden Elements 5 wenigstens im Querschnittsbereich des Ringkernwandlers 4 bezogen auf dessen Mittellängsachse 25 derart annähernd punktsymmetrisch ausgebildet ist, daß jedem Leiter (Hinleiter 10a, Rückleiter 11a) oder Leiterquerschnittselement 12a gegenüberliegend ein entsprechender, parallel geschalteter Leiter (Hinterleiter 10b, Rückleiter 11b) oder ein entsprechendes, parallel geschaltetes Leiterquerschnittselement 12b angeordnet ist.

## Beschreibung

Die Erfindung betrifft ein Laborprüfgerät zur Ermittlung der Isolationsqualität eines daran zu Prüfzwecken anschließbaren Verbrauchers. Derartige Laborprüfgeräte werden dazu herangezogen, mittels einer Differenzstrommessung zu überprüfen, ob der Verbraucher in Form irgend eines elektrischen Gerätes, die vorgeschriebenen Isolationseigenschaften hat oder unzulässige Ströme über den Isolationsbereich abfließen, so daß eine Gefährdung der Benutzer oder mit einem solchen Gerät in Kontakt stehender weiterer Personen nicht ausgeschlossen werden kann.

Es ist ein Laborprüfgerät bekannt, das mit einer Kontakteinrichtung in Form einer Steckdose zum Anschluß des zu vermessenden Verbrauchers versehen ist. In die Steckdose kann der Netzstecker des zu vermessenden Verbrauchers eingesteckt werden. Es ist aber genau so gut möglich, anstatt der Steckdose Steckbuchsen oder sonstige elektrische Anschlußklemmen vorzusehen.

Im Inneren des Laborprüfgerätes wird ein Ringkernwandler zur Durchführung eines Differenzstromverfahrens verwendet, durch den das zur Kontakteinrichtung verlaufende stromführende Element hindurchgeführt ist. Der Verbraucher wird demnach über das Laborprüfgerät bestromt. Die zum Verbraucher fließenden Ströme können durch den Ringkernwandler abgetastet werden. Die in dem Ringkemwandler dabei induzierte Spannung ist ein Maß für die Qualität der Isolation (dieses Verfahren sollte an dieser Stelle noch etwas ergänzt werden).

Beim Stand der Technik werden herkömmliche Netzkabel durch einen Ringkernwandler geführt, so daß durch die übliche Leiteranordnung infolge von Streufeldern ein Gleichtakteinfluß wirksam wird, der zu einer Fehlerbelastung des Meßergebnisses führt. Die angestrebte Meßauflösung bis hin zu Strömen von 10 µA wird deswegen nur selten und mühsam erreicht.

Der Erfindung liegt die Aufgabe zugrunde, ein Laborprüfgerät derart zu verbessern, daß Gleichtaktfehler vermieden werden. Diese Aufgabe wird dadurch gelöst, daß der durch den Ringkernwandler hindurchführende Abschnitt der stromführenden Elemente wenigstens im Querschnittsbereich des Ringkernwandlers, bezogen auf dessen Mittellängsachse annähernd punktsymmetrisch ausgebildet ist derat, daß jedem Leiter, d.h. sowohl dem Hinleiter als auch dem Rückleiter oder Leiterquerschnittselement gegenüberliegend ein entsprechender, parallel geschalteter Leiter oder ein entsprechendes parallel geschaltetes Leiterquerschnittselement angeordnet ist oder sind. Mit anderen Worten bedeutet dies, daß gleichgepolte Leiter oder Leiterquerschnittselemente (falls man den Leiterquerschnitt betrachtet) gleich verteilt um die Mittellängsachse angeordnet sind. Somit müssen symmetrisch zur Mittellängsachse beispielsweise zwei als Hinleiter wirkende und zwei als Rückleiter wirkende Kabel vorgesehen sein, um eine gewisse Punktsymmetrisierung des gesamten Leiterquerschnitts zu erreichen. Jeder Leiter findet genau auf der entgegengesetzten Seite der Mittellängsachse seinen entsprechenden gleichgepolten ,,Partner"-Leiter wieder.

Als erste Möglichkeit bietet es sich an, den durch den Ringkernwandler und der hindurchführende Abschnitt als Koaxialkabel auszubilden. Der Mittelleiter des Koaxialkabels läuft konzentrisch zur Mittellängsachse des Ringkernwandlers, der Außen- oder Mantelleiter des Koaxialkabels ist ebenfalls konzentrisch bezogen auf die Mittellängsachse des Ringkernwandlers angeordnet. Dadurch ist sichergestellt, daß Hin- und Rückleiter absolut symmetrisch und gleich verteilt um die Mittellängsachse des Ringkernwandlers herum angeordnet sind.

Alternativ ist es auch möglich, den durch den Ringkernwandler hindurchführenden Abschnitt des, den Betriebsstrom zum Verbraucher führenden Abschnitts als symmetrisch aufgebautes Kabel mit einer geradzahligen Anzahl von n-Leitungen auszubilden, wobei n ≥ 4 ist.

Die Mehrzahl der Leitungen ist innerhalb des Abschnitts gleichmäßig verseilt, so daß dem in den vorhergehenden Ansprüchen geschilderten Symmetrieerfordernis Genüge getan ist.

Der Abschnitt des stromführenden Elementes steht beidseitig aus dem Ringkernwandler heraus. Die Überstehlänge ist so bemessen, daß an den Abschnitt ein- oder beidseitig angeschlossene andere Leitungen das Abtastfeld des Ringkernwandlers nicht mehr negativ beeinflussen können. Außerdem ist ein Überstehen des Abschnitts über die Stirnseiten des Ringkernwandlers auch insofern vorteilhaft, als der Abschnitt auf einfache Weise an weiterführende Leitungen angeschlossen werden kann. Es ist natürlich auch möglich, das stromführende Element zwischen der Kontakteinrichtung und dem Ringkernwandler durchgängig der Ausbildung des Abschnitts innerhalb des Ringkernwandlers entsprechen zu lassen, d.h. durchgängig symmetrisch, im Sinne des Patentanspruchs 1 auszubilden.

Der Abschnitt muß nicht notwendigerweise als Kabel oder dgl. ausgebildet sein. Mit Vorteil läßt sich der Abschnitt auch als starrer Körper in Form eines Vergußblocks aus Isolationsmaterial ausbilden, in dem die Leiter punktsymmetrisch bezogen auf seine Mittellängsachse verlaufen, wobei die Mittellängsachse mit der Mittellängsachse des Ringkernwandlers fluchtet. Der Körper steht beidseitig über den Ringkernwandler hinaus, um das Abtastfeld des Ringkernwandlers durch nichtsymmetrisierte Leiterabschnitte nicht negativ zu beeinflussen. An dem Körpers sind beidendseitig Steckanschlüse zum Anschluß der weiterführenden Leitungen angeordnet. Der Körper kann ferner integraler

Bestandteil des Ringkemwandlers sein und in den Ringkernwandler eingegossen oder insgesamt mit diesem vergossen sein, so daß der stromführende Körper zusammen mit dem Ringkernwandler eine Einheit bildet und auch einheitlich hergestellt, montiert und gegebenenfalls ausgetauscht werden kann.

Die Erfindung ist anhand vorteilhafter Ausführungsbeispiele in den Zeichnungsfiguren näher erläutert. Diese zeigen:
- Fig. 1: eine schematisierte, perspektivische Darstellung eines Ringkernwandlers mit einem stromführenden Abschnitt in koaxialer Ausführung,
- Fig. 2: eine schematische Querschnittsdarstellung des Abschnitts innerhalb des Ringkernwandlers zur Darlegung der Leitungsverhältnisse,
- Fig. 3: eine schematische Querschnittsdarstellung eines alternativen Leitungsquerschnitts innerhalb des Ringkernwandlers,
- Fig. 4: eine weitere Alternative gemäß Fig. 3,
- Fig. 5: eine weitere Alternative gemäß Fig. 3 und 4 sowie
- Fig. 6: eine schematische Darstellung der für die Erfindung wesentlichen Elemente eines Laborprüfgerätes mit einem daran zu Prüfzwecken angeschlossen Verbraucher.

Zunächst wird auf Zeichnungsfig. 6 Bezug genommen. Dort ist schematisch ein Laborprüfgerät 1 angedeutet, bei dem allerdings nur die für die Erfindung wesentlichen Teile dargestellt sind. Das Laborpürfgerät 1 dient zur Ermittlung der Isolationsqualität eines daran zu Prüfzwecken anschließbaren Verbrauchers 2, der über eine Kontakteinrichtung 3 in Form einer Steckdose an das Laborprüfgerät 1 angeschlossen ist. Ferner umfaßt das Laborprüfgerät 1 einen Ringkernwandler 4, durch den das zur Kontakteinrichtung 3 verlaufende stromführende Element 5 hindurchgeführt ist. Die Ausgangsanschlüsse 6 sind mit einer Auswerte- und/oder Anzeigeeinrichtung 7 verbunden, um ein bei der Differenzstrommessung erzeugtes Induktionsspannungssignal, als Maß der Isolationsqualität des anschließbaren Verbrauchers 2, anzeigen zu können.

Der durch den Ringkernwandler 4 hindurchgehende Abschnitt 8 des stromführenden Elementes 5 ist wenigstens im Querschnittsbereich des Ringkernwandlers 4 bezogen auf dessen Mittellängsachse derart annähernd punktsymmetrisch ausgebildet, daß jedem Leiter (Hinleiter 10a, Rückleiter 11a) oder Leiterquerschnittselement 12a gegenüberliegend ein entsprechender, parallel geschalteter Leiter (Hinleiter 10b, Rückleiter 11b) weiteres Leiterquerschnittselement 12b angeordnet ist.

Nachfolgende wird auf die Zeichnungsfig. 1 - 5 Bezug genommen, die Näheres über die Anordnung der Leiter innerhalb des Ringkernwandlers 4 aussagen.

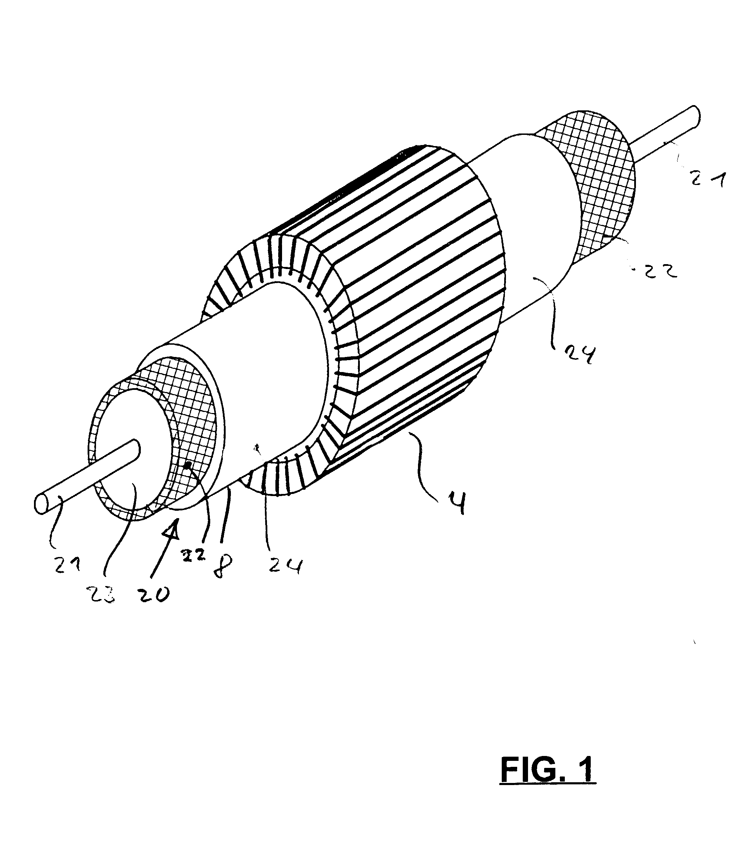

In Fig. 1 ist der Ringkernwandler 4 dargestellt, durch den der Abschnitt 8 hindurchführt, der bei dem in Fig. 1 dargestellten Ausführungsbeispiel als Koaxialkabel 20 ausgebildet ist. Das Koaxialkabel 20 weist einen Mittelleiter 21 und einen koaxial schlauchartigen Mantelleiter 22 auf, der vom Mittelleiter 21 durch eine Isolationsschicht 23 getrennt ist. Der Mantelleiter 22 ist von einer Mantelisolation 24 umgeben.

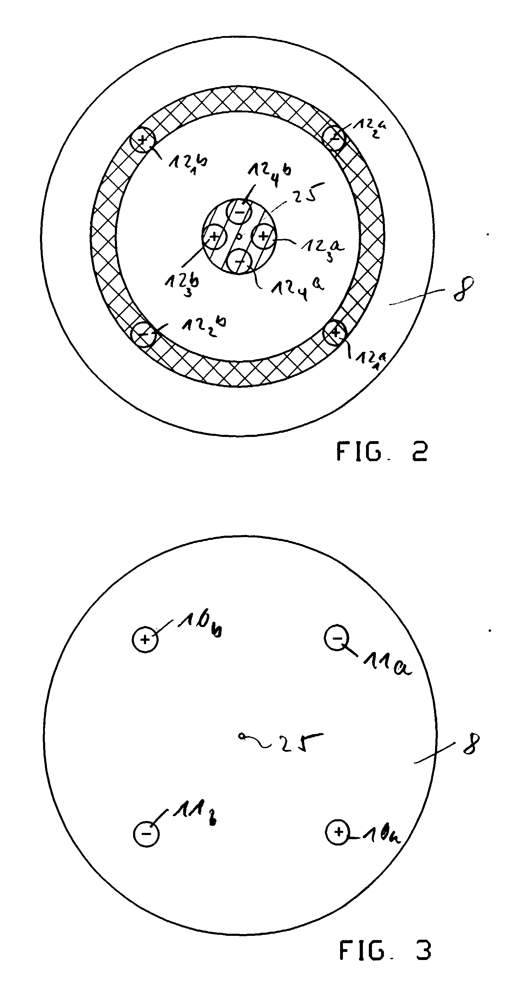

Aus Fig. 2 wird deutlich, daß jedem Leiterquerschnittselement 12a, bezogen auf die Mittellängsachse 25, gegenüberliegend ein entsprechendes, parallel geschaltetes Leiterquerschnittselement 12b liegt. Zur Verdeutlichung sind die Leiterquerschnittselemente 12a, 12b mit zuordnenden Indizes versehen, nämlich 12₁a , 12₁b, 12₂a, 12₂b usw.. Natürlich wäre es denkbar, in diesem Koaxialmodell eine Vielzahl weiterer Leiterquerschnittselemente einzuzeichnen, was aber aus Übersichtlichkeitsgründen unterlassen ist.

Bei dem in Fig. 3 dargestellten Ausführungsbeispiel ist der Abschnitt 8 als Vierleiter ausgebildet, d.h. jedem Hinleiter 10a und Rückleiter 11a liegt ein entsprechender weiterer Hinleiter 10b bzw. Rückleiter 11b bezogen auf die Mittellängsachse 25 gegenüber, so daß der Symmetriebedingung des Patentanspruchs 1 Genüge getan ist.

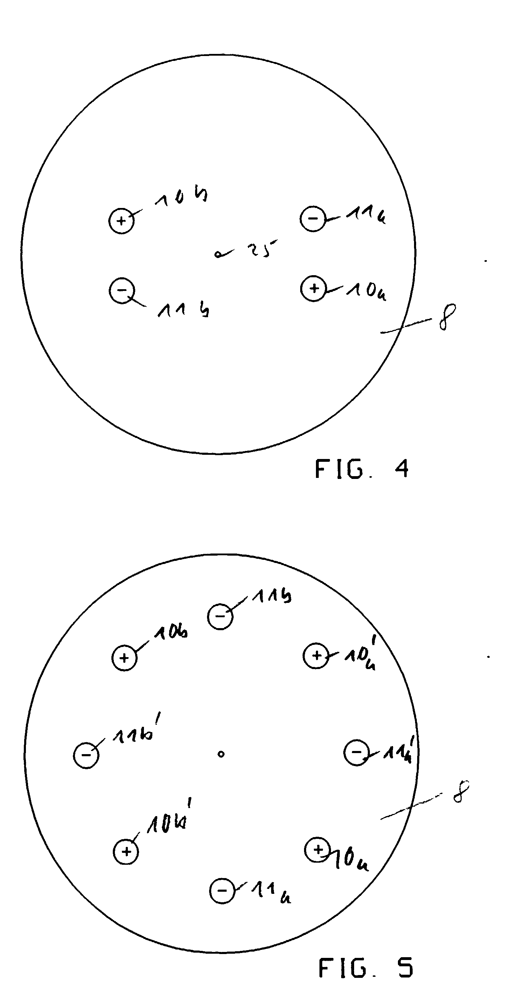

Bei dem in Fig. 4 dargestellten Ausführungsbeispiel sind die Hin- und Rückleiter 10a und 11a nicht quadratförmig um die Mittellängsachse 25 des Abschnitts 8 herum angeordnet, sondern nach Art eines Rechtecks.

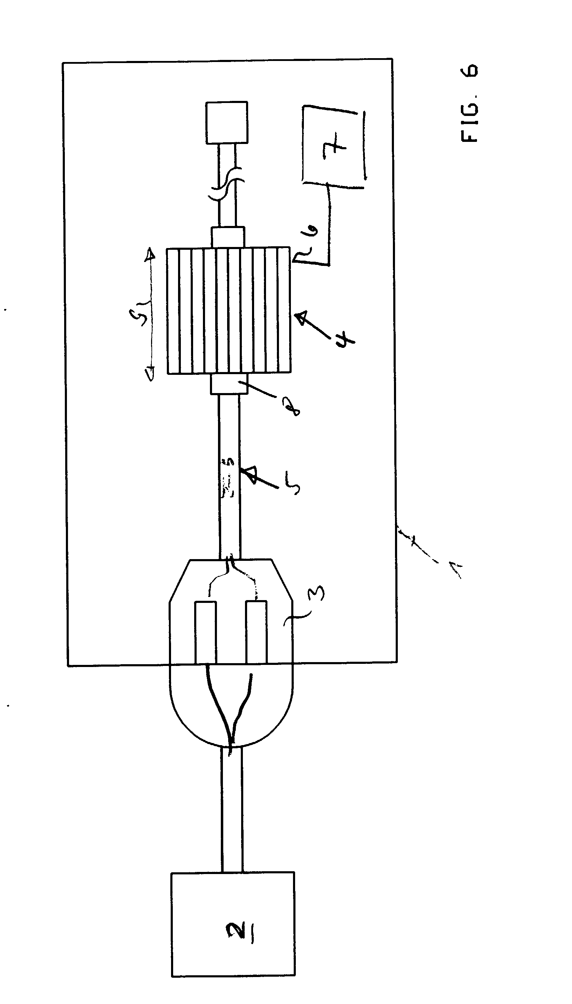

Bei dem in Fig. 5 dargestellten Ausführungsbeispiel handelt es sich um einen Mehrfachleiter mit acht Einzelleitungen, d.h. vier Hinleitern 10, 10b 10a' 10b' und vier Rückleitern 11a, 11b, 11a', 11b'. Auch eine derartige Anordnung genügt der Symmetriebedingung gemäß Patentanspruch 1.

### BEZUGSZEICHEN

- 1: Laborprüfgerät
- 2: Verbraucher
- 3: Kontakteinrichtung
- 4: Ringkernwandler
- 5: stromführendes Element
- 6: Ausgangsanschluß
- 7: Auswerte- oder Anzeigeeinrichtung
- 8: Abschnitt

- 10a: Hinleiter
- 10a': Hinleiter
- 10b: Hinleiter
- 10b': Hinleiter
- 11a: Rückleiter
- 11a': Rückleiter
- 11b: Rückleiter
- 11b': Rückleiter
- 12a: Leiterquerschnittselement
- 12b: Leiterquerschnittselement

- 20: Koaxialkabel
- 21: Mittelleiter
- 22: Mittelleiter
- 23: Isolationsschicht
- 24: Mantelisolation
- 25: Mittellängsachse

## Patentansprüche

1. Laborprüfgerät (1) zur Ermittlung der Isolationsqualität eines daran zu Prüfzwekken anschließbaren Verbrauchers (2) mit
- einer Kontakteinrichtung (3) (Steckdose, Steckbuchsen, Klemmen) zum Anschluß des zu vermessenden Verbrauchers (2) und
- einem Ringkernwandler (4) zur Durchführung eines Differenzstromverfahrens,
-- durch den das zur Kontakteinrichtung (3) verlaufende stromführende Element (5) hindurch geführt ist und
-- dessen Ausgangsanschlüsse (6) mit einer Auswerte- oder Anzeigeeinrichtung (7) verbunden sind, um ein bei der Differenzstrommessung erzeugtes Induktionsspannungssignal als Maß der Isolationsqualität des anschließbaren Verbrauchers (2) anzeigen zu können,
**dadurch gekennzeichnet**,
daß
- der durch den Ringkernwandler (4) hindurchgehende Abschnitt (8) des stromführenden Elements (5) wenigstens im Querschnittsbereich des Ringkernwandlers (4) bezogen auf dessen Mittellängsachse (25) derart annähernd punktsymmetrisch ausgebildet ist, daß jedem Leiter (Hinleiter 10a, Rückleiter 11a) oder Leiterquerschnittselement 12a gegenüberliegend ein entsprechender, parallel geschalteter Leiter (Hinterleiter 10b, Rückleiter 11b) oder ein entsprechendes, parallel geschaltetes Leiterquerschnittselement 12b angeordnet ist.

2. Laborprüfgerät nach Anspruch 1,
**dadurch gekennzeichnet**,
daß der durch den Ringkernwandler (4) hindurchführende Abschnitt (8) als Koaxialkabel (20) ausgebildet ist.

3. Laborprüfgerät nach Anspruch 1,
**dadurch gekennzeichnet**,
daß der durch den Ringkernwandler (4) hindurchführende Abschnitt (8) als symmetrisch aufgebauter Mehrfachleiter mit einer geradzahligen Anzahl von n-Leitungen (Vierleiter, Sechsleiter usw.) ausgebildet ist, wobei die Zahl n ≥ 4 ist.

4. Laborprüfgerät nach Anspruch 3,
**dadurch gekennzeichnet**,
daß die Leitungen (10a, 10b, 11a, 11b) verseilt sind.

5. Laborprüfgerät nach einem der vorhergehenden Ansprüche,
**dadurch gekennzeichnet**,
daß der Abschnitt (8) des stromführenden Elements (5) beidseitig aus dem Ringkernwandler (4) heraussteht.

6. Laborprüfgerät nach einem der vorhergehenden Ansprüche,
**dadurch gekennzeichnet**,
daß das stromführende Element (5) zwischen der Kontakteinrichtung (3) und dem Ringkernwandler (4) durchgängig der Ausbildung des Abschnitts (8) innerhalb des Ringkernwandlers (4) entspricht.

7. Laborprüfgerät nach einem der vorhergehenden Ansprüche,
**dadurch gekennzeichnet**,
daß der Abschnitt (8) als starrer Körper (Isolatorvergußblock) ausgebildet ist, in dem die Leiter punktsymmetrisch bezogen auf seine Mittellängsachse (25) verlaufen.

8. Laborprüfgerät nach Anspruch 7,
**dadurch gekennzeichnet**,
daß der Körper über den Ringkernwandler (4) beidseitig hinaussteht.

9. Laborprüfgerät nach Anspruch 7 oder 8,
**dadurch gekennzeichnet**,
daß an dem Körper beidsendseitig Steckanschlüsse zum Anschluß der weiterführenden Leitungen angeordnet sind.

10. Laborprüfgerät nach einem der vorhergehenden Ansprüche,
**dadurch gekennzeichnet**,
daß der Körper integraler Bestandteil des Ringkernwandlers (4) ist.

11. Laborprüfgerät nach Anspruch 10,
**dadurch gekennzeichnet**,
daß der Körper als Isolatorvergußblock in den Ringkernwandler (4) eingegossen oder mit diesem insgesamt vergossen ist.
